Europäisches Patentamt

European Patent Office

Office européen des brevets

(11) Publication number: **0 112 034**
**B1**

(12) **EUROPEAN PATENT SPECIFICATION**

(45) Date of publication of patent specification: **02.03.88**

(21) Application number: **83306858.8**

(22) Date of filing: **10.11.83**

(51) Int. Cl.⁴: **H 01 L 27/02, H 01 L 23/52**

(54) **A MIS integrated circuit device protected from static charge.**

(30) Priority: **03.12.82 JP 212461/82**

(43) Date of publication of application:
**27.06.84 Bulletin 84/26**

(45) Publication of the grant of the patent:
**02.03.88 Bulletin 88/09**

(84) Designated Contracting States:
**DE FR GB**

(56) References cited:
**DE-A-3 027 954**
**GB-A-2 092 826**
**US-A-4 332 839**

**EXTENDED ABSTRACTS, Vol. 82-2, October 1982, page 252, abstractno. 159, PENNINGTON NEW JERSEY (US) A. SINHA: "Interconnect Materials Technology for VLSI**

**SOLID STATE TECHNOLOGY, vol. 24, no.1, January 1981, pages 65-72,92 PORT WASHINGTON, NEW YORK (US) F. MOHAMMADI: "Silicides for Interconnection Technology".**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro c/o Fujitsu Limited**
**Patent Department 1015 Kamikodanaka Nakahara-ku**
**Kawasaki-shi Kanagawa 211 (JP)**

(74) Representative: **Sunderland, James Harry et al HASELTINE LAKE & CO Hazlitt House 28 Southampton Buildings Chancery Lane London WC2A 1AT (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

The present invention relates to MIS (Metal Insulator Semiconductor) type integrated circuits (ICs) protected from damage caused by static charge. It involves a protection circuit placed between an input terminal and the IC circuit, to decrease the susceptibility of the IC to static charge break down.

Static charge break down is a problem affecting ICs during handling, especially MIS type ICs. As a result some ICs which have been passed by testing nevertheless malfunction when mounted on a printed circuit board.

The problem of static charge break down is to some extent inherent for an MIS IC because, in general, an input terminal of the MIS IC will be connected to a gate electrode of a MIS transistor. The gate electrode is insulated by a gate oxide layer, whose electric insulator factor is very high, so the gate is apt to be charged to a high voltage by static charge. The break down voltage (gradient) of gate oxide is about $7 \times 10^6$ V/cm. The thickness of gate oxide layer, in recent MIS ICs, especially for large scale integrated circuits (LSI), is as little as 300 to 1000 Å (10 Å = 1 nm).

This means that a voltage from static charge of about 20 to 70 V is sufficient to break down the insulating gate oxide layer, so destroying the MIS transistor.

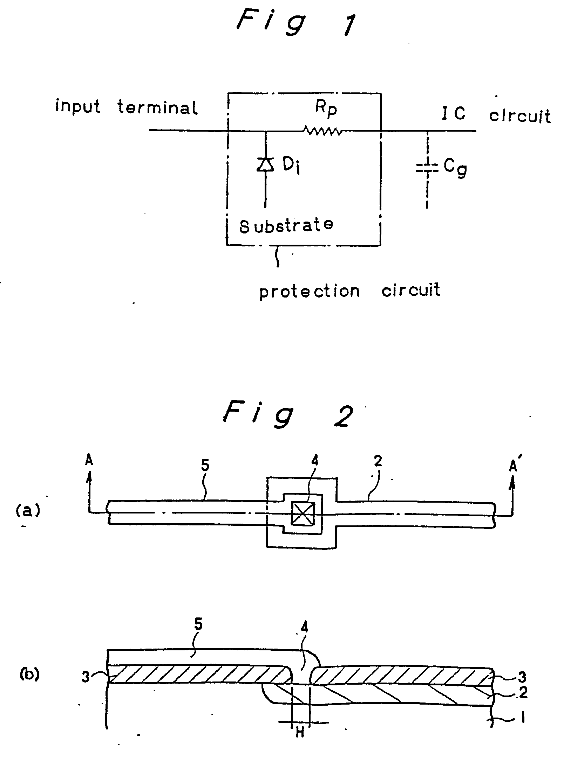

In order to avoid this problem, a MIS IC is usually provided with a protection circuit whose equivalent circuit is shown in Fig. 1. A clamp diode Di has a break down voltage less than that of the gate, namely about 15 to 60 V, and so breaks down more easily than the gate when static charge is present. The static charge thus leaks through the diode to the substrate, and the gate oxide layer is protected from break down.

When static charge is given a conducting path, a surge of voltage results. The series resistor $R_p$, and inner capacitance $C_g$, which comprises the gate capacitance and stray capacitance of the wiring circuit, make up a delay circuit, which limits the surge of voltage presented to the IC, until the static charge has leaked to the substrate.

In the above mentioned protection circuit, the clamp diode and the series resistance are usually fabricated by a diffusion process. The junction between the diffused region and the substrate works as a clamp diode, and the inner resistance of the diffused region works as a series resistor.

As the required resistance of ICs against static charge increases, it becomes apparent that such a protection circuit has some weaknesses. Fig. 2 shows schematically the structure of a formerly used static charge protection circuit. In the Figure, (a) is a plan view and (b) is a cross sectional view, sectioned substantially along the chained line A—A' in (a). 1 is a semiconductor substrate, 2 is a diffusion region, 3 is an isolation layer, 4 is a contact window for wiring, and 5 is an input line made of aluminium.

In such a protecting circuit, when a surge voltage is introduced to the input line 5, the junction break down current of the diffusion region 2, which works as a clamp diode, concentrates mainly at the point where the input line 5 is connected to the region 2. So, the temperature of the portion designated H in Fig. 2(b) becomes very high.

Consequently, in a structure in which the aluminium input line is connected directly to the diffusion region, as shown in Fig. 2, a portion of the aluminium line close to the contact point H melts causing a disconnection. In some cases the melted aluminium penetrates deep into the diffusion region 2, damaging the junction and causing a short circuit of the input line 5 to the substrate.

It should be noted that usually a voltage surge is induced by rapid change of current, but in the present context a surge occurs by break down of or touching to the accumulated charge. The impulsive effect is the same in both cases for an IC. The term surge should be understood to have this broader meaning hereinafter.

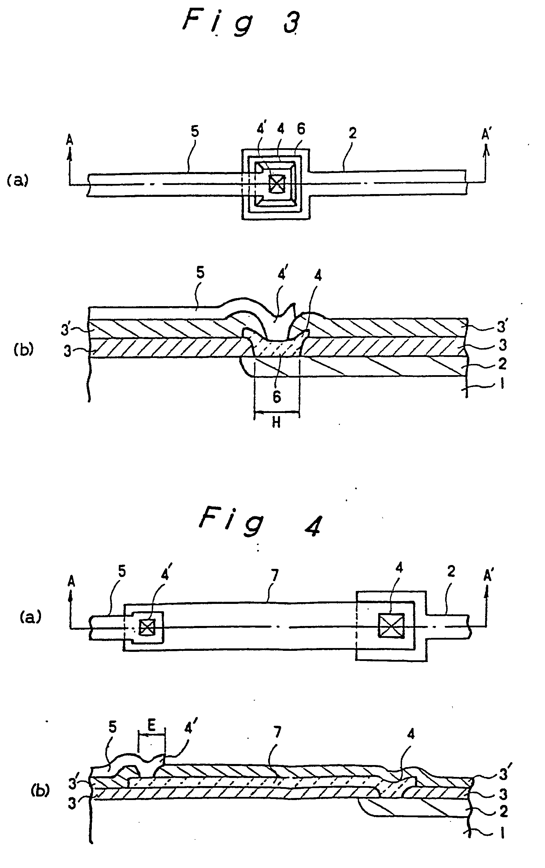

Trial proposals have been made for overcoming this problem. Fig. 3 shows one example. The Figure shows parts of a protection circuit corresponding to parts shown in Fig. 2. 1 is a semiconductor substrate, 2 is a diffusion region, and 3 is an insulation layer. Again, (a) and (b) in the Figure are a plan view and a cross sectional view, respectively.

As can be seen in the Figure, the contact window 4 is filled with conductive polycrystalline silicon (polysilicon) 6. The input line 5 is connected to the diffusion region 2 via the polysilicon 6. In the Figure another insulation layer 3' is shown. This layer is an oxidized layer of polysilicon produced in the process of fabricating the contact 6. The input line 5 is contacted to the polysilicon 6 through a contact window 4' opened in the insulation layer 3'.

The structure of Fig. 3 is intended to prevent the melting of the contact portion by inserting polysilicon, which has aong polysilicon, which has a high melting point, in the contact window. However, this step is found insufficient to prevent melting, because contact is still made at the small portion H in the Figure, which reaches a high temperature. Moreover, there is the drawback that the process of fabrication is made more complicated.

Another trial proposal was to make contact with the diffusion region via a pattern of polysilicon 7 as shown in Fig. 4. This Figure shows corresponding parts to those in Figs. 2 and 3.

In the Figure, 1, 2 and 3 designate a substrate, diffusion region and insulation layers respectively. As can be seen in the Figure, an elongated pattern 7 of conductive polysilicon is fabricated on the surface of insulation layer 3. One end of the pattern 7 is contacted to the diffusion layer 2 through a contact window 4 opened in the insulation layer 3. The input line 5 is contacted to the polysilicon pattern 7 at the other end of the pattern, through a contact window 4' opened on the other insulation layer 3', which again is an oxidised layer of polysilicon.

It was expected that, since the input line 5 is now separated from the contact portion of diffusion region 2, the heat generated at the contact portion would not affect the input line 5. But it was found that the polysilicon pattern 7 is heated by the current running through it, causing melting down of the input line. The explanation for this is that the conductivity of polysilicon is not very high and moreover it is covered by the silicon dioxide layer 3', which is a heat insulator. So, the polysilicon pattern 7 is raised to a very high temperature, causing the melting down of both the polysilicon pattern and the aluminium input line.

This problem may be avoided by making the polysilicon pattern large (wide and long), but it is not practical to do so, because this increases the stray capacitance of the input line, and decreases the packing density of devices possible to achieve on the IC.

According to the present invention there is provided a MIS IC device provided with a static charge protection circuit connected to an aluminium input line thereof, said protection circuit comprising a diffusion region and an elongated conductive pattern, characterised in that said conductive pattern is of a high melting point metal or silicide of such a metal having a sheet resistivity less than a few $\Omega$ per square, the elongated conductive pattern being connected at one end to the input line and at the other end to the diffusion region.

An embodiment of the present invention can provide a protection circuit for static charge break down, and increase the resistance of an MIS IC against static charge break down.

This can be achieved by providing a protection circuit including a diffusion region which works as a clamp diode and as a series resistor, in which the input line of the circuit makes contact with the diffusion region via an elongated contact pattern made of conducting material with a high melting point.

Reference is made, by way of example, to the accompanying drawings in which:—

Fig. 1 shows an equivalent circuit of a static charge protection circuit;

Fig. 2 shows schematically in plan and cross-section the construction of a previously proposed circuit for static charge protection;

Fig. 3 shows schematically an example of a proposed improvement to the static charge protection circuit of Fig. 2;

Fig. 4 shows schematically a further proposed improvement to the static charge protection circuit of Fig. 2;

Fig. 5 shows schematically a static charge protection circuit embodying the present invention; and

Fig. 6 shows schematically another static charge protection circuit embodying the present invention.

In each of Figs. 2 to 6, (a) is a plan view and (b) is a corresponding cross sectional view taken in the direction of the arrows substantially along the chained line A—A' in the plan view.

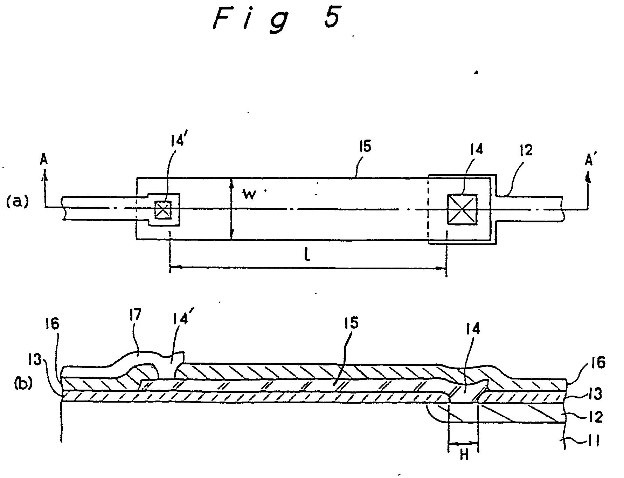

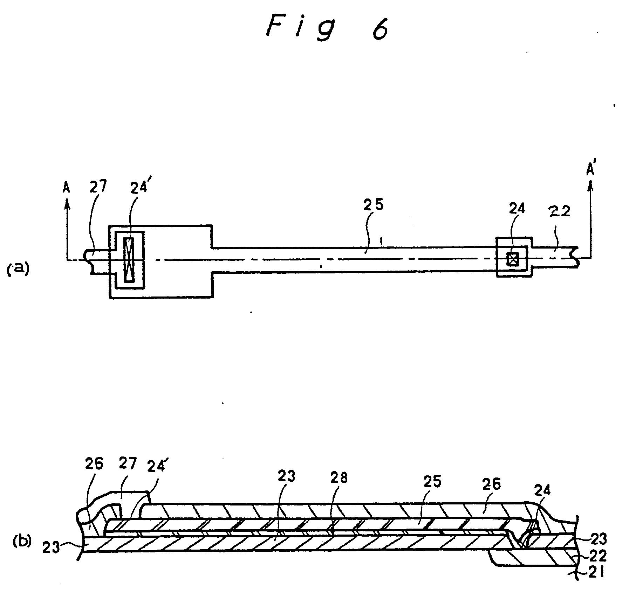

In the following description a substrate, 11 in Fig. 5, 21 in Fig. 6, is assumed to have p-type conductivity as an example. In fact, the substrate may be of any conductivity type. If an n-type conductivity substrate is used, the following processes should use materials with opposite type conductivity to that stated. Also, the material of the substrate may be any kind of semiconductor, but in the following explanation it is assumed to be silicon.

In Fig. 5, 12 is a diffusion region whose conductivity type is opposite to that of the substrate; that is n-type in this example. It provides a clamp diode and works also as a series resistor. 13 is a first insulation layer which is composed of silicon dioxide ($SiO_2$) fabricated on the substrate 11. 14 and 14' designate first and second contact windows respectively opened in the first insulation layer 13 and a second insulation layer 16. 15 is a conductive pattern preferably made of molybdenum silicide ($MoSi_2$). 16 is a second insulation layer, composed of PSG, for example. 17 is an input line made of aluminium.

Manufacturing a device of the above configuration requires only conventional fabrication processes. For instance, the diffusion region 12 is fabricated by a diffusion process, the first and second isolation (insulation) layers 13 and 16 may be fabricated by chemical vapour deposition or oxidation, contact windows 14 and 14' are opened by photo-lithography, and the conductive pattern 15 can be fabricated by sputtering and photo-lithography, and so on.

As can be seen by comparison with the foregoing Figures, this embodiment of a protection circuit according to the present invention is formed with a diffusion layer 12, one end of which is connected to the conductive pattern 15, which is made of molybdenum silicide, a high melting point material, via a first contact window 14 in the first insulation layer 13.

Generally the thickness of this molybdenum silicide conductive pattern 15 is a few thousand Å. The shape of the conductive pattern may be varied according to the layout of the entire pattern on the IC. For instance, its width w may be 2 to 10 μm and its length l may be 10 to 500 μm. The aluminium input line 17 is fabricated on the surface of the second insulation layer 16, which covers the conductive pattern 15. It contacts the other end of the conductive pattern 15, via a second contact window 14' opened on the second insulation layer 16. It will be clear that the second contact window 14' is placed apart from the contact point H of conductive pattern 15 and diffusion region 12, where the most of the heat is generated by the break down current. In practice, another insulation layer covers the entire surface of the device to protect the surface of the IC.

Concerning the material of the conductive pattern 15, high melting point metals such as tungsten, molybdenum and so on, or silicides of metals such as platinum, tungsten, molybdenum, titanium and so on are recommended. It is desirable for the sheet resistivity (sheet resistance) of the conductive pattern to be less than a few Ω per square.

For the fabrication of the conductive pattern, any conventional technique for semiconductor manufacturing may be applied. For example, spattering, or co-spattering (cooperative spattering) may be used for fabricating a conductive layer of molybdenum, tungsten and so on. Any kind of photo-lithographical technology may be used for patterning.

Fig. 6 shows another embodiment of the present invention. Comparing Fig. 6 to Fig. 5, it is provided with a polycrystalline silicon layer 28 fabricated under a conductive pattern 25. On the substrate 21, is fabricated a diffusion region 22, providing a clamp diode and a series resistor. The surface of the substrate is coated with a first insulation layer 23.

The diffusion region 22 is connected to the conductive pattern 25 at a contact window 24, via an under layer 28. The under layer 28 is made of phosphor(us) or arsenic doped conductive polysilicon. This thickness of the under layer 28 can range from approximately a few hundreds Å to a few thousands Å. The sheet resistance of the under layer is a few tens of Ω per square. The under layer 28 is sandwiched between the first insulation layer 23 and the conductive pattern 25. The conductive pattern 25, the second insulation layer 26 and input line 27 are the same as in Fig. 5. The input line 27 contacts the conductive pattern 25 through a second contact window 24' opened on the second insulation layer 26.

The configuration of Fig. 6 has an advantage over that of Fig. 5, although it requires some additional processing to fabricate the polysilicon layer 28. The type of device shown in Fig. 5 sometimes suffers from migration of the metals used for the conductive pattern. For example, molybdenum atoms may migrate into the substrate and cause the break down of the clamp diode. The sandwiched polysilicon layer 28 prevents such problems. A sandwiched polysilicon layer in the type of device shown in Fig. 4, suffers from overheating. But in this case, polysilicon under-layer 28 is covered by a conductor (that is, the conductive pattern 25) such that the electrical conductivity is good compared to Fig. 4, and the polysilicon does not melt.

The longer the conductive pattern can be made, the better. Of course this is limited by the design of the IC circuit. By elongating the pattern, thermal conduction is increased, and temperature is reduced so that migration of metal or melting of polysilicon is further reduced.

For the fabrication of the polysilicon under-layer 28, a conventional semiconductor process such as chemical vapour deposition, sputtering and photo-lithography and so on, can be applied.

As has been described above, an embodiment of a static charge protection circuit according to the present invention has a structure such that the contact point of the input line to the protection circuit is placed apart from the contact point of the clamp diode at which the greatest heating occurs during static charge breakdown of the clamp diode. The melting down of the input line or the contact point are hence prevented. In one embodiment described, the migration of metals at the contact point is also prevented.

Static charge break down can be simulated by a condenser discharge. An IC which has no protection circuit has been found to fail due to the discharge of a 300 pF capacitor charged up to a few tens of volts. An IC incorporating a previously proposed protection circuit has been found to withstand up to 300 volts. But an IC which is protected by a circuit in accordance with the present invention, is able to withstand more than twice that voltage. Recently, increasingly high resistance of ICs to static charge break down is becoming required. Therefore the effect of the present invention is apparent.

## Claims

1. A MIS IC device provided with a static charge protection circuit connected to an aluminium input line (17) thereof, said protection circuit comprising a diffusion region (12) and an elongated conductive pattern (15), characterised in that said conductive pattern is of a high melting point metal or silicide of such a metal having a sheet resistivity less than a few Ω per square, the elongated conductive pattern (15) being connected at one end to the input line (17) and at the other end to the diffusion region (12).

2. A MIS IC device as claimed in claim 1, wherein the protection circuit further comprises a conductive polysilicon under-layer (28) beneath said conductive pattern.

3. A MIS IC device as claimed in claim 2, in which the resistivity of said conductive polysilicon under-layer (28) is less than a few tens Ω per square.

4. A MIS IC device as claimed in claim 2 or 3, in which the thickness of said conductive polysilicon under-layer (28) is less than a few hundred nm.

5. A MIS IC device as claimed in claim 4, in which the thickness of said polysilicon under-layer (28) is from a few tens to a few hundreds nm.

6. A MIS IC device as claimed in any preceding claim, in which the conductive pattern is of high melting point metal which includes at least one of tungsten and molybdenum.

7. A MIS IC device as claimed in any one of claims 1 to 5, in which the conductive pattern (15) is of at least one of molybdenum silicide, platinum silicide, tungsten silicide and titanium silicide.

8. A MIS IC device as claimed in any preceding claim, in which one end of said conductive pattern (15) is connected to said diffusion region (12) through a contact window or hole (14) fabricated in a first insulation layer (13) which separates said conductive pattern (15) from said diffusion region (12), and the other end of said conductive pattern (15) is connected to the said input line (17) of the device through a contact window or hole (14') fabricated in a second insulation layer (16) which separates said conductive pattern (15) from said input line (17).

9. A MIS IC device as claimed in claim 8, in which said first insulation layer (13) and said second insulation layer (16) are made of silicon dioxide.

10. A MIS IC device as claimed in any preceding claim, being a silicon MIS IC.

**Patentansprüche**

1. MIS-IC-Vorrichtung mit einer statischen Ladungsschutzschaltung, die mit einer Aluminiumeingangsleitung (17) derselben verbunden ist, wobei die genannten Schutzschaltung einen Diffusionsbereich (12) und ein längliches leitendes Muster (15) umfaßt, dadurch gekennzeichnet, daß das genannte leitende Muster aus einem Metall mit hohem Schmelzpunkt oder dem Silizid eines solchen Metalls besteht und einen Schichtwiderstand hat, der kleiner als einige wenige Ohm pro Quadrat ist, wobei das längliche leitende Muster (15) an einem Ende mit der Eingangsleitung (17) und an dem anderen Ende mit dem Diffusionsbereich (12) verbunden ist.

2. MIS-IC-Vorrichtung nach Anspruch 1, bei der die Schutzschaltung ferner eine leitende Polysilizium-Unterschicht (28) unter dem genannten leitenden Muster umfaßt.

3. MIS-IC-Vorrichtung nach Anspruch 2, bei der der Widerstand der genannten leitenden Polysilizium-Unterschicht (28) kleiner als einige 10-tel Ohm pro Quadrat ist.

4. MIS-IC-Vorrichtung nach Anspruch 2 oder 3, bei der die Dicke der genannten leitenden Polysilizium-Unterschicht (28) weniger als wenige 100 nm ist.

5. MIS-IC-Vorrichtung nach Anspruch 4, bei der die Dicke der genannten Polysilizium-Unterschicht (28) zwischen einigen wenigen 10 und einigen wenigen 100 nm liegt.

6. MIS-IC-Vorrichtung nach einem der vorhergehenden Ansprüche, bei der das leitende Muster aus einem Metall mit hohem Schmelzpunkt besteht, welches wenigstens Wolfram oder Molybdän enthält.

7. MIS-IC-Vorrichtung nach einem der Ansprüche 1 bis 5, bei der das leitende Muster (15) aus wenigstens einem von Molybdänsilizid, Platinsilizid, Wolframsilizid und Titansilizid besteht.

8. MIS-IC-Vorrichtung nach einem der vorhergehenden Ansprüche, bei der ein Ende des genannten leitenden Musters (15) mit dem genannten Diffusionsbereich (12) durch ein Kontaktfenster oder ein Loch (14) verbunden ist, das in der ersten Isolationsschicht (13) hergestellt ist, welche das leitende Muster (15) von dem genannten Diffusionsbereich (12) trennt, und das andere Ende des genannten leitenden Musters (15) mit der genannten Eingangsleitung (17) der Vorrichtung durch ein Kontaktfenster oder ein Loch (14') verbunden ist, das in der zweiten Isolationsschicht (16) hergestellt ist, die das genannte leitende Muster (15) von der genannten Eingangsleitung (17) trennt.

9. MIS-IC-Vorrichtung nach Anspruch 8, bei der die genannte erste Isolationsschicht (13) und die genannte zweite Isolationsschicht (16) aus Siliziumdioxid bestehen.

10. MIS-IC-Vorrichtung nach einem der vorhergehenden Ansprüche, die ein Silizium-MIS-IC ist.

**Revendications**

1. Dispositif à circuit intégré CI à métal-isolant-semiconducteur MIS pourvu d'un circuit de protection contre les charges statiques connecté à une ligne d'entrée en aluminium (17) de celui-ci, le circuit de protection comprenant une région de diffusion (12) et un dessin conducteur allongé (15), caractérisé en ce que le dessin conducteur est constitué d'un métal ou de siliciure de ce métal au point de fusion élevé ayant une résistivité de couche inférieure à quelques Ω au carré, le dessin conducteur allongé (15) étant connecté par une extrémité à la ligne d'entrée (17) et par l'autre extrémité à la région de diffusion (12).

2. Dispositif à circuit CI à MIS selon la revendication 1, dans lequel le circuit de protection comprend en outre une sous-couche de silicium polycristallin conductrice (28) au-dessous de ce dessin conducteur.

3. Dispositif à circuit CI à MIS selon la revendication 2, dans lequel la résistivité de la sous-couche de silicium polycristallin conductrice (28) est inférieure à quelques dizaines de Ω au carré.

4. Dispositif à circuit CI à MIS selon l'une quelconque des revendications 2 et 3, dans lequel l'épaisseur de la sous-couche de silicium polycristallin conductrice (28) est inférieure à quelques centaines de nanomètres.

5. Dispositif à circuit CI à MIS selon la revendication 4, dans lequel l'épaisseur de la sous-couche de silicium polycristallin (28) est comprise entre quelques dizaines et quelques centaines de nanomètres.

6. Dispositif à circuit CI à MIS selon l'une quelconque des revendications 1 à 5, dans lequel le dessin conducteur est constitué d'un métal au point de fusion élevé qui comprend au moins un métal parmi le tungstène et le molybdène.

7. Dispositif à circuit CI à MIS selon l'une quelconque des revendications 1 à 5, dans lequel le dessin conducteur (15) est constitué d'au moins un siliciure parmi le siliciure de molybdène, le siliciure de platine, le siliciure de tungstène et le siliciure de titane.

8. Dispositif à circuit CI à MIS selon l'une quelconque des revendications 1 à 7, dans lequel une extrémité du dessin conducteur (15) est connectée à la région de diffusion (12) par une fenêtre ou un trou (14) de contact fabriqué dans une première couche isolante (13) qui sépare le dessin conducteur (15) de la région de diffusion (12), et l'autre extrémité du dessin conducteur (15) est connectée à la ligne d'entrée (17) du dispositif par une fenêtre ou un trou de contact (14') fabriqué dans une deuxième couche isolante (16) qui sépare le dessin conducteur (15) de la ligne d'entrée (17).

9. Dispositif à circuit CI à MIS selon la revendication 8, dans lequel la première couche isolante (13) et la deuxième couche isolante (16) sont constituées de dioxyde de silicium.

10. Dispositif à circuit CI à MIS selon l'une quelconque des revendications 1 à 9, qui est un circuit CI à MIS au silicium.

# Fig 1

input terminal       $R_p$       IC circuit

$D_i$

$C_g$

Substrate

protection circuit

# Fig 2

(a)

A     5     4     2     A'

(b)

5     4

3            3

2

1

H

# Fig 3

(a)

(b)

# Fig 4

(a)

(b)

# Fig 5

(a)

(b)

# Fig 6

(a)

(b)